Europäisches Patentamt

European Patent Office

Office européen des brevets

(19)

(11) Veröffentlichungsnummer: **0 119 159**

**A1**

(12) **EUROPÄISCHE PATENTANMELDUNG**

(21) Anmeldenummer: 84730023.3

(22) Anmeldetag: 14.03.84

(51) Int. Cl.³: **H 03 K 17/08**
H 02 H 3/087

(30) Priorität: 14.03.83 DE 3309492

(43) Veröffentlichungstag der Anmeldung:
19.09.84 Patentblatt 84/38

(84) Benannte Vertragsstaaten:
AT CH DE IT LI

(71) Anmelder: Siemens Aktiengesellschaft
Berlin und München Wittelsbacherplatz 2
D-8000 München 2(DE)

(72) Erfinder: Geerligs-Wilm, Manfred, Dipl.-Ing.
Körtestrasse 38
D-1000 Berlin 61(DE)

(54) Anordnung mit einem Schalttransistor.

(57) Die Erfindung bezieht sich auf eine Anordnung mit einem Schalttransistor, mit dem in Reihe ein Verbraucher an eine Betriebsspannungsquelle angeschlossen ist. Eine elektronische Schutzanordnung enthält einen Steuertransistor, über den der Schalttransistor anschaltbar ist.

Um eine derartige Anordnung so weiterzuentwickeln, daß sie möglichst vielseitig einsetzbar ist, enthält die elektronische Schutzanordnung (8) einen Spannungsteiler (9) mit einer Z-Diode (10), die über eine Spule (14) parallel zum Kollektor-Emitter-Pfad des Schalttransistors (1) angeordnet ist. Ein von der Spannung am Spannungsteiler abhängig gesteuerter elektronischer Schalter (17) beeinflußt die Steuerung des Schalttransistors (1) durch den Steuertransistor (18).

Die Erfindung ist bei Anordnungen mit einem Schalttransistor anwendbar.

EP 0 119 159 A1

SIEMENS AKTIENGESELLSCHAFT
Berlin und München

Unser Zeichen
VPA 83 P 4022 E

Anordnung mit einem Schalttransistor

Die Erfindung bezieht sich auf eine Anordnung mit einem Schalttransistor, mit dessen Kollektor-Emitter-Pfad ein Verbraucher in Reihe an eine Betriebsspannungsquelle angeschlossen ist, und mit einer elektronischen Schutzanordnung, die einen Steuertransistor enthält, dessen Basis-Anschluß mit einem Steuereingang der Anordnung und dessen zweiter Anschluß mit einem Pol der Betriebsspannungsquelle in Verbindung steht, während der dritte Anschluß des Steuertransistors an den Basis-Anschluß des Schalttransistors geführt ist.

Bei einer bekannten Anordnung dieser Art (DE-OS 25 28 425) ist ein Verbraucher einerseits an einen Pol der Betriebsspannungsquelle und andererseits über eine in Sperrichtung geschaltete Diode mit einem Schaltungspunkt verbunden, der über einen Widerstand mit einem Steuereingang der Anordnung und über eine weitere Diode mit dem Basis-Anschluß des Steuertransistors in Verbindung steht. Tritt an dem Verbraucher ein Kurzschluß auf, dann bewirkt der verringerte Spannungsabfall an ihm eine Potentialabsenkung an der Kathode der einen Diode, so daß diese nunmehr in Durchlaßrichtung geschaltet ist. Es wird daraufhin der Steuertransistor gesperrt, wodurch infolge der Verbindung seines Kollektor-Anschlusses mit dem Basis-Anschluß des Schalttransistors auch der Schalttransistor gesperrt wird. Es fließt dann kein Strom mehr durch den Schalttransistor, so daß dieser im Falle eines Kurzschlusses im Verbraucher vor einer Beschädigung geschützt ist.

Der Erfindung liegt die Aufgabe zugrunde, die bekannte Anordnung so weiterzuentwickeln, daß sie vielseitiger einsetzbar ist, beispielsweise auch in solchen Fällen, wo über mehrere

Kr 3 Sz / 11.03.1983

unabhängig voneinander ansteuerbare Schalttransistoren der Verbraucher einschaltbar ist.

Zur Lösung dieser Aufgabe enthält bei einer Anordnung der eingangs angegebenen Art die elektronische Schutzanordnung einen Spannungsteiler mit einer Z-Diode, der über eine Spule parallel zum Kollektor-Emitter-Pfad des Schalttransistors angeordnet ist; an einen Abgriff des Spannungsteilers ist ein Betätigungseingang eines elektronischen Schalters angeschlossen, der einerseits an die Basis des Schalttransistors und andererseits an den anderen Pol der Betriebsspannungsquelle angeschlossen ist, und der Steuertransistor liegt mit seinem Kollektor-Emitter-Pfad parallel zum Spannungsteiler.

Bei der erfindungsgemäßen Anordnung ist die Z-Diode vorteilhafterweise eine Diode mit einem Schwellenwert, der unterhalb der Spannung der Betriebsspannungsquelle um höchstens einen Betrag liegt, der der Induktionsspannung in der Spule infolge Anlegens eines Signals an den Steuereingang der Anordnung entspricht. Ist die Betriebsspannungsquelle hinsichtlich der von ihr bereitzustellenden Spannung nur mit einer gewissen Toleranz einstellbar, dann ist als Spannung der Betriebsspannungsquelle hinsichtlich der Auswahl der Z-Diode die Spannung heranzuziehen, die minimal zulässig ist.

Ein wesentlicher Vorteil der erfindungsgemäßen Anordnung besteht darin, daß bei ihr die Spannung am Schalttransistor von der elektronischen Schutzanordnung erfaßt wird und nicht – wie bei der bekannten Anordnung – der Spannungsabfall am Verbraucher überwacht wird. Dies erlaubt es nämlich, mit einem Verbraucher mehrere Schalttransistoren mit ihrem Kollektor-Emitter-Pfad in Reihe an eine einzige Betriebsspannungsquelle anzuschließen, wobei jedem Schalttransistor eine elektronische Schutzanordnung mit einem Steuertransistor zugeordnet ist, der für sich getrennt an seinem Steuereingang mit einem Signal beaufschlagbar ist. Auf diese Weise läßt sich dann beispielsweise ein Relais als Verbraucher redundant über mehrere Steuertransistoren und diesen nachgeordneten Schalttransistoren nur dann betätigen, wenn alle Schalttransistoren durchgeschaltet sind, wobei auch in einem solchen Falle sichergestellt ist, daß bei einem Kurzschluß im Verbraucher bzw. Relais die Schalttransistoren gesperrt sind und damit vor Beschädigungen oder Zerstörung durch unzulässig hohe Ströme geschützt sind.

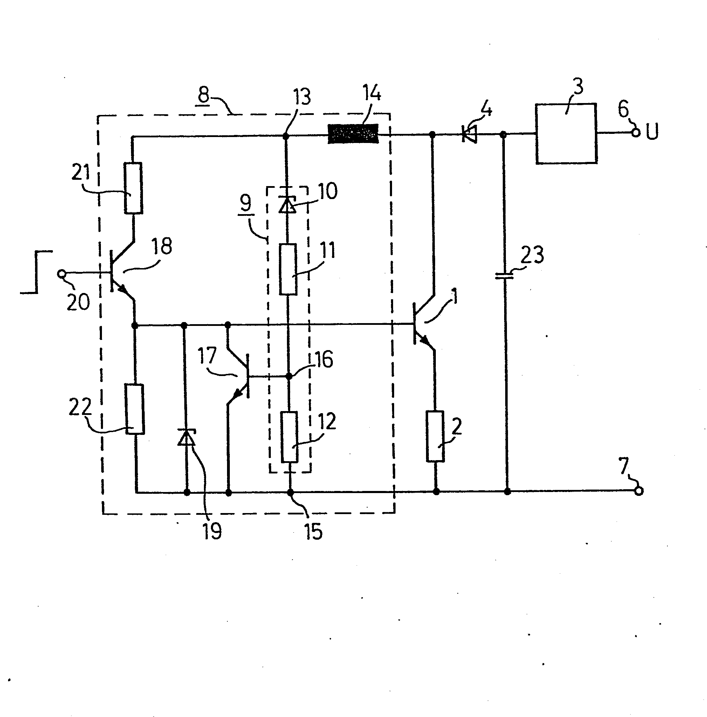

Zur Erläuterung der Erfindung ist in der Figur ein Ausführungsbeispiel der erfindungsgemäßen Anordnung dargestellt.

Die Anordnung enthält einen Schalttransistor 1, der in seinem Kollektor-Emitter-Pfad einen Widerstand 2 und einen Verbraucher 3 damit in Reihe aufweist. Eine Diode 4 ist als Verpolungsschutz vorgesehen. Die so gebildete Reihenschaltung ist an eine Klemme 6 einer nicht dargestellten Bestriebsspannungsquelle angeschlossen, die eine Spannung U aufweist; eine weitere Klemme 7 der Betriebsspannungsquelle liegt auf Massepotential.

Eine elektronische Schutzanordnung 8 enthält einen Spannungsteiler 9, der eine Z-Diode 10 in Reihe mit Widerständen 11 und 12 aufweist und parallel zum Kollektor-Emitter-Pfad des Schalttransistors 1 mit dem Widerstand 2 liegt. Bei der Z-Diode kann es sich um eine Zener- Diode oder um eine Avalanche-Diode handeln. Ein Anschlußpunkt 13 des Spannungsteilers 9 ist über eine Spule 14 mit der Kathode der Diode 4 bzw. mit dem Kollektor-Anschluß des Schalttransistors 1 verbunden. Ein weiterer Anschlußpunkt 15 des Spannungsteilers 9 ist mit der Klemme 7 verbunden. Ein Abgriff 16 des Spannungsteilers 9 ist an den Basis-Anschluß bzw. Betätigungseingang eines Transistors 17 geführt, der als elektronischer Schalter wirkt und mit seinem Kollektor-Anschluß an den
Basis-Anschluß des Schalttransistors 1 sowie an den Emitter-
Anschluß eines Steuertransistors 18 geführt ist. Der Emitter-
Anschluß des Transistors 17 ist mit der Klemme 7 verbunden.
Parallel zur Kollektor-Emitter-Strecke des Transistors 17 ist
eine weitere Z-Diode 19 angeordnet. Diese Diode und der Widerstand 2 haben zur Folge, daß der Transistor 1 als Stromquelle
wirkt. Beide Bauelemente können entfallen; der Transistor 1
arbeitet dann als Schalter.

Der Basis-Anschluß des Steuertransistors 18 bildet einen
Steuereingang 20 der Anordnung. Der Kollektor-Anschluß des
Transistors ist über einen Widerstand 21 mit dem Anschlußpunkt 13 verbunden, während der Emitter-Anschluß des Steuertransistors 18 über einen zusätzlichen Widerstand 22 mit der
Klemme 7 der Betriebsspannungsquelle in Verbindung steht.

Ein an den gemeinsamen Anschlußpunkt der Diode 4 und des
Verbrauchers 3 einerseits und an die Klemme 7 andererseits
angeschlossene Kondensator 23 dient als Störspannungsschutz.

Die dargestellte Anordnung wirkt in folgender Weise:
Liegt kein Signal am Eingang 20 der Anordnung und ist daher
der Steuertransistor 18 gesperrt, dann tritt am Anschlußpunkt 13 des Spannungsteilers 9 etwa die Spannung U der nicht
dargestellten Betriebsspannungsquelle auf. Da der Schwellenwert der Z-Diode 10 so gewählt ist, daß er unterhalb der
Spannung U der Betriebsspannungsquelle liegt, leitet die
Z-Diode 10, und es tritt eine Steuerung des elektronischen
Schalters bzw. des Transistors 17 in den leitenden Zustand
ein.

Wird an den Steuereingang 20 ein Signal in Form eines
Spannungssprungs gegeben, dann wird der Steuertransistor 18
leitend, und es fließt ein Strom durch die Spule 14, der in dieser eine Induktionsspannung dergestalt hervorruft, daß die Spannung am Anschlußpunkt 13 absinkt. Da eine Z-Diode 10 mit einem solchen Schwellenwert eingesetzt ist, daß durch diese Induktionsspannung die Spannung am Spannungsteiler 9 unterhalb des Schwellenwertes sinkt, sperrt nunmehr die Z-Diode 10 mit der Folge, daß auch der elektronische Schalter bzw. Transistor 17 gesperrt wird. Von dem Steuertransistor 18 wird nunmehr der Schalttransistor 1 durchgeschaltet und damit der Verbraucher 3 angeschlossen. Dies wiederum führt zu einem Spannungsabfall am Verbraucher 3 und damit zu einer solchen Spannung am Anschlußpunkt 13 des Spannungsteilers 9, daß der Schwellenwert der Z-Diode 10 unterschritten bleibt, wodurch der elektronische Schalter 17 weiterhin gesperrt bleibt. Ergibt sich im Verbraucher 3 ein Kurzschluß oder ist der Verbraucher 3 aufgrund eines Schaltungsfehlers so angeordnet, daß die Anode der Diode 4 direkt mit der Klemme 6 verbunden ist, dann liegt die Spannung U der nicht dargestellten Betriebsspannungsquelle unmittelbar an dem einen Anschlußpunkt 13 des Spannungsteilers 9, woraufhin dann die Z-Diode 10 wieder leitend wird; es wird der elektronische Schalter 17 betätigt. Es wird daraufhin der Schalttransistor 1 sofort gesperrt und damit vor einer Beschädigung oder Zerstörung durch einen zu hohen Strom geschützt.

1 Figur
2 Patentansprüche

Patentansprüche

1. Anordnung mit einem Schalttransistor, mit dessen Kollektor- Emitter-Pfad ein Verbraucher in Reihe an eine Betriebsspannungsquelle angeschlossen ist, und mit einer elektronischen Schutzanordnung, die einen Steuertransistor enthält, dessen Basis-Anschluß mit einem Steuereingang der Anordnung und dessen zweiter Anschluß mit einem Pol der Betriebsspannungsquelle in Verbindung steht, während der dritte Anschluß des Steuertransistors an den Basis-Anschluß des Schalttransistors geführt ist, d a d u r c h   g e k e n n z e i c h n e t , daß die elektronische Schutzanordnung (8) einen Spannungsteiler (9) mit einer Z-Diode (10) enthält, daß der Spannungsteiler (9) über eine Spule (14) parallel zum Kollektor-Emitter-Pfad des Schalttransistors (1) angeordnet ist, daß an einen Abgriff (16) des Spannungsteilers (9) ein Betätigungseingang eines elektronischen Schalters (17) angeschlossen ist, der einerseits an die Basis des Schalttransistors (1) und andererseits an den anderen Pol (7) der Betriebsspannungsquelle angeschlossen ist und daß der Steuertransistor (18) mit seinem Kollektor-Emitter-Pfad parallel zum Spannungsteiler (9) liegt.

2. Anordnung nach Anspruch 1 , d a d u r c h   g e k e n n -  z e i c h n e t , daß die Z-Diode (10) eine Diode mit einem Schwellenwert ist, der unterhalb der Spannung (U) der Betriebsspannungsquelle um höchstens einen Betrag liegt, der der Induktionsspannung in der Spule (14) infolge Anlegens eines Signals an den Steuereingang (20) der Anordnung entspricht.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| Y | US-A-3 449 598  (WRIGHT) <br> * Insgesamt * | 1 | H 03 K  17/08 <br> H 02 H   3/08 |
| Y | DE-A-1 946 874  (SIEMENS) <br> * Figur; Seite 4, vorletzte Zeile - Seite 5, Zeile 16; Anspruch 3 * | 1 | |
| Y | GB-A-2 020 504  (LUCAS) <br> * Insgesamt * | 1 | |
| A | FR-A-2 008 826  (PHILLIPS) <br> * Figur 2; Seite 4, Zeile 16 - Seite 5, Zeile 4 * | 1 | |
| A | EP-A-0 046 962  (SIEMENS) <br> * Zusammenfassung; Figur * | 1 | |
| | | | **RECHERCHIERTE SACHGEBIETE (Int. Cl. ³)** |
| D,A | DE-A-2 528 425  (SINE) | | H 03 K <br> H 02 H |

-----

Der vorliegende Recherchenbericht wurde für alle Patentansprüche erstellt.

| Recherchenort <br> DEN HAAG | Abschlußdatum der Recherche <br> 15-05-1984 | Prüfer <br> KOLBE W.H. |
|---|---|---|